Europäisches Patentamt

European Patent Office

Office européen des brevets

(19)

(11) Numéro de publication : **0 474 528 A1**

## (12) DEMANDE DE BREVET EUROPEEN

(21) Numéro de dépôt : **91402220.7**

(22) Date de dépôt : **09.08.91**

(51) Int. Cl.⁵ : **C11D 7/50,** C23G 5/028

(30) Priorité : **14.08.90 FR 9010342**

(43) Date de publication de la demande :
**11.03.92 Bulletin 92/11**

(84) Etats contractants désignés :
**AT BE CH DE DK ES FR GB GR IT LI LU NL SE**

(71) Demandeur : **ATOCHEM**
**4 & 8, Cours Michelet La Défense 10**
**F-92800 Puteaux (FR)**

(72) Inventeur : **Desbiendras, Daniel**
**7 Rue Maurice Ravel**
**F-93430 Villetaneuse (FR)**
Inventeur : **Martin, Jean-Jacques**
**15 Avenue Vitel**
**F-92270 Bois-Colombes (FR)**
Inventeur : **Michaud, Pascal**
**35 Boulevard Pasteur**
**F-95210 Saint Gratien (FR)**

(74) Mandataire : **Leboulenger, Jean et al**
**ATOCHEM Département Propriété Industrielle**
**F-92091 Paris la Défense 10 Cédex 42 (FR)**

(54) **Composition nettoyante à base de 1,1-dichloro-1-fluoroéthane, de chlorure de méthylène et de méthanol.**

(57)  Pour remplacer les compositions de nettoyage à base de 1,1,2-trichloro-1,2,2-trifluoroéthane (F113), l'invention propose une composition comprenant en poids 60 à 98,9 % de 1,1-dichloro-1-fluoroéthane (F141b), 0,1 à 39 % de chlorure de méthylène et 1 à 39,9 % de méthanol.

La composition, éventuellement stabilisée, peut être utilisée pour le nettoyage de surfaces solides, en particulier pour le défluxage des circuits imprimés et pour le dégraissage de pièces mécaniques.

EP 0 474 528 A1

La présente invention concerne le domaine des hydrocarbures chlorofluorés et a plus particulièrement pour objet une nouvelle composition utilisable comme agent de nettoyage et de dégraissage de surfaces solides, en particulier dans le défluxage et le nettoyage à froid de circuit imprimés.

Le 1,1,2-trichloro-1,2,2-trifluoroéthane (connu dans le métier sous la désignation F113) est largement utilisé dans l'industrie pour le nettoyage et le dégraissage des surfaces solides. Outre son application en électronique au nettoyage des flux de soudure pour éliminer le flux décapant qui adhère aux circuits imprimés, on peut mentionner ses applications au dégraissage de pièces métalliques lourdes et au nettoyage de pièces mécaniques de haute qualité et de grande précision comme par exemple, les gyroscopes et le matériel militaire ou aérospatial. Dans ses diverses applications, le F113 est le plus souvent associé à d'autres solvants organiques (par exemple le méthanol), de préférence sous forme de mélanges azéotropiques ou pseudo-azéotropiques qui ne démixent pas et qui, employés au reflux, ont sensiblement la même composition dans la phase vapeur que dans la phase liquide.

Cependant, le F113 fait partie des chlorofluorocarbures complètement halogénés qui sont actuellement suspectés d'attaquer ou de dégrader l'ozone stratosphérique.

Pour résoudre ce problème, on a déjà proposé de remplacer le F113 par divers hydrochloroflurocarbures et notamment par le 1,1-dichloro-1-fluoroéthane. Ce composé, connu dans le métier sous la désignation F141b, est pratiquement dépourvu d'effet destructeur vis-à-vis de l'ozone.

Son application au nettoyage a récemment fait l'objet de nombreuses publications qui concernent, pour la plupart, des compositions azéotropiques ou pseudo-azéotropiques à base de F141b et d'un ou plusieurs solvants ; voir par exemple les demandes de brevets japonais publiées sous les numéros 124195/87 (F141b + n-propanol), 124196/87 (F141b + méthylcyclohexane), 124197/87 (F141b + 3-méthyl-1-butyn-3-ol), 124198/87 (F141b + acétonitrile + n-propanol, isobutanol ou 2-butanol), 127398/87 (F141b + isopropylacétate + isobutanol), 132539/89 (F141b + méthanol, éthanol, isopropanol, tétrahydrofuranne ou méthyléthylcétone + stabilisant), la demande de brevet EP 0325265 (F141b + méthanol ou éthanol) et les brevets US 4 816 174 et 4 842 764 (F141b + méthanol + éventuellement nitrométhane).

D'une façon beaucoup plus générale, la demande de brevet japonais publiée sous le n° 132693/89, relative à des agents de nettoyage pour l'élimination des flux décapants, mentionne qu'on peut ajouter au F141b un ou plusieurs solvants organiques choisis parmi les hydrocarbures, les alcools, les cétones et les hydrocarbures chlorés. Cette référence cite plus d'une centaine de tels solvants, mais les seuls à être concrètement exemplifiés sont le n-heptane, le méthanol, l'acétone et le trichloréthylène sous forme de compositions binaires à 75 % de F141b et 25 % de cosolvant.

Le pouvoir nettoyant des combinaisons binaires F141b + méthanol n'est pas toujours suffisant et, pour certaines applications, il apparait souvent nécessaire de le renforcer par l'addition d'un autre solvant. Le choix de cet autre solvant n'est pas évident lorsqu'en même temps on exige que la composition de nettoyage soit ininflammable et ait un comportement pseudo-azéotropique.

Il a maintenant été trouvé qu'on peut parvenir à ce résultat au moyen de chlorure de méthylène. Les compositions de nettoyage selon l'invention sont caractérisées en ce qu'elles comprennent en poids 60 à 98,9 % de F141b, 1 à 39,9 % de méthanol et 0,1 à 39% de chlorure de méthylène.

On préfère plus particulièrement les compositions comprenant en poids 80 à 90 % de F141 b, 1 à 15 % de méthanol et 5 à 19 % de chlorure de méthylène.

Bien que les trois constituants ne forment pas d'azéotrope vrai, leurs mélanges peuvent être employés dans une machine de nettoyage dans les mêmes conditions que les compositions à base de F113. En effet, l'un des principaux avantages des compositions selon l'invention réside dans le fait inattendu que, quelle que soit la proportion de chaque constituant, la composition de la phase vapeur est sensiblement la même que celle de la phase liquide. Cette propriété permet de moduler le pouvoir solvant de la composition nettoyante et donc de l'adapter à volonté en fonction de la surface à nettoyer ou à dégraisser.

Les compositions selon l'invention ne possèdent pas de point éclair dans les conditions standard de détermination et peuvent donc être employées sans danger.

Comme dans les compositions connues à base de F113, les compositions selon l'invention peuvent être avantageusement stabilisées contre l'hydrolyse et/ou les attaques radicalaires susceptibles de survenir dans les processus de nettoyage, en y ajoutant un stabilisant usuel tel que, par exemple, le nitro-methane, l'oxyde de propylène ou un mélange de ces composés, la proportion de stabilisant pouvant aller de 0,01 à 5 % par rapport au poids total : F141b + chlorure de méthylène + méthanol.

Les compositions selon l'invention peuvent être utilisées dans les mêmes applications et selon les mêmes techniques que les compositions antérieures à base de F113.

Les exemples suivants illustrent l'invention sans la limiter.

## EXEMPLE 1

Dans une cuve de nettoyage à ultra-sons Annemasse, on introduit un mélange de F141b, de chlorure de méthylène et de méthanol dans les proportions mentionnées dans le tableau suivant. Le mélange est ensuite mis à reflux total pendant une heure pour amener le système à l'équilibre, puis à l'aide d'une seringue on effectue un prélèvement de quelques millilitres dans la goulotte de la machine recueillant le condensat. La fraction recueillie ainsi qu'un échantillon du contenu de la cuve sont ensuite analysés, après refroidissement, par chromatographie en phase gazeuse.

Le tableau suivant rassemble des résultats obtenus dans trois essais correspondant à différents mélanges selon l'invention. Leur examen montre que les compositions (% en poids) du mélange de départ, de la fraction recueillie (phase vapeur) et du pied de cuve sont sensiblement identiques.

|  | Essai 1 | Essai 2 | Essai 3 |
|---|---|---|---|
| **Mélange de départ** | | | |
| F141 b | 86,4 | 80 | 80 |
| chlorure de méthylène | 10 | 10 | 15 |
| méthanol | 3,6 | 10 | 5 |
| **Phase vapeur** | | | |
| F141 b | 86,5 | 80,3 | 83 |
| chlorure de méthylène | 9,9 | 8,7 | 13 |
| méthanol | 3,6 | 11 | 4 |
| **Cuve** | | | |
| F141 b | 86,4 | 80 | 80 |
| chlorure de méthylène | 10 | 10 | 15 |
| méthanol | 3,6 | 10 | 5 |
| **Température d'ébullition** | | | |
| (corrigée pour 1,013 bar) | 29,9°C | 30,2°C | 30,3°C |

A titre comparatif, on a reproduit l'Essai 1, mais en remplaçant le chlorure de méthylène par d'autres hydrocarbures chlorés, à savoir le trichloro-1,1,1 éthane (T111), le tétrachlorure de carbone, le trichloréthylène (TRI) et le perchloréthylène (PER).

L'examen des résultats, consignés dans le tableau suivant, montre que, contrairement au chlorure de méthylène, ces hydrocarbures chlorés conduisent à une composition de la phase vapeur très différentes de celle de la phase liquide.

| Essai comparatif n° | 4 | 5 | 6 | 7 | Essai 1 |
|---|---|---|---|---|---|
| Hydrocarbure chloré | T111 | $CCl_4$ | TRI | PER | $CH_2Cl_2$ |
| **Mélange initial (% Poids)** | | | | | |
| - F141 b | 86,4 | 86,4 | 86,4 | 86,4 | 86,4 |
| - méthanol | 3,6 | 3,6 | 3,6 | 3,6 | 3,6 |
| - hydrocarbure chloré | 10 | 10 | 10 | 10 | 10 |

Phase vapeur (% poids)

|  | | | | | |
|---|---|---|---|---|---|
| - F141 b | 93,2 | 92,7 | 93,2 | 94,9 | 86,5 |
| - méthanol | 4,1 | 4,1 | 4,1 | 4,2 | 3,6 |
| - hydrocarbure chloré | 2,7 | 3,2 | 2,7 | 0,9 | 9,9 |

**EXEMPLE 2**

Dans une cuve de nettoyage à ultra-sons, on introduit 150 g d'un mélange contenant en poids 86,3 % de F141b, 10 % de chlorure de méthylène, 3,6 % de méthanol et 0,1 % de nitrométhane comme stabilisant. Après avoir mis le système à reflux pendant une heure, on prélève un aliquat de la phase vapeur. Son analyze par chromatographie en phase gazeuse montre la présence de nitrométhane ce qui indique que le mélange est stabilisé dans la phase vapeur.

|  | COMPOSITION (% poids) | | | |
|---|---|---|---|---|
|  | F141b | $CH_2Cl_2$ | Méthanol | $CH_3NO_2$ |
| Mélange initial | 86,3 | 10 | 3,6 | 0,1 |
| Phase vapeur | 86,4 | 10 | 3,59 | 0,01 |

**EXEMPLE 3**

Si on répète l'exemple 2 en remplaçant le nitrométhane par l'oxyde de propylène, on obtient les résultats suivants:

|  | COMPOSITION (% poids) | | | |
|---|---|---|---|---|
|  | F141b | $CH_2Cl_2$ | Méthanol | $C_3H_6O$ |
| Mélange initial | 86,3 | 10 | 3,6 | 0,1 |
| Phase vapeur | 86,4 | 10 | 3,58 | 0,02 |

**EXEMPLE 4**

Dans une cuve à ultra-sons Annemasse, on introduit 200 g de la composition selon l'Essai 1, puis on porte le mélange à la température d'ébullition.

Des circuits imprimés, enduits de flux de soudure et recuits à l'étuve pendant 30 secondes à 220°C, sont plongés durant 3 minutes dans le liquide à l'ébullition sous ultra-sons, puis rincés dans la phase vapeur pendant 3 minutes.

Après séchage à l'air, on constate l'absence totale de résidu de flux de soudure.

**Revendications**

1. Composition nettoyante comprenant en poids de 60 à 98,9 % de 1,1-dichloro-1-fluoroéthane, de 0,1 à 39 % de chlorure de méthylène, et de 1 à 39,9 % de méthanol.

2. Composition selon la revendication 1 contenant en poids de 80 à 90 % de 1,1-dichloro-1-fluoroéthane, de 5 à 19 % de chlorure de méthylène, et de 1 à 15 % de méthanol.

3. Composition selon la revendication 1 ou 2, comprenant en outre au moins un stabilisant.

4. Composition selon la revendication 3, dans laquelle le stabilisant est le nitrométhane, l'oxyde de propylène ou un mélange de ces composés.

5. Composition selon la revendication 3 ou 4, dans laquelle la proportion de stabilisant est de 0,01 à 5 % par rapport au poids total du mélange : 1,1-dichloro-1-fluoroéthane - chlorure de méthylène + méthanol.

6. Application d'une composition selon l'une des revendications 1 à 5 au nettoyage des surfaces solides.

7. Application selon la revendication 6 au défluxage des circuits imprimés et au dégraissage des pièces mécaniques.

Office européen
des brevets

# RAPPORT DE RECHERCHE EUROPEENNE

Numero de la demande

EP    91 40 2220

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| X | WO-A-9 008 814 (ASAHI GLASS CO.)<br>* page 7, ligne 22 - ligne 27; revendications 1,3,5,6,7 * | 1-4,6,7 | C11D7/50<br>C23G5/028 |
| X | WPIL, FILE SUPPLIER,accession no. 89-202303 (28) Derwent, Publications Ltd., Londres, GB;<br>& JP-A-1 140 154 (ASAHI GLASS CO.) 1 Juin 1989<br>* abrégé * | 1,2,6,7 | |
| X | WPIL, FILE SUPPLIER, access. no. 89-195725(27), Derwent Publications Ltd., Londres; GB<br>& JP-A-1 132 693 (ASAHI GLASS CO.) 25 Mai 1989<br>* abrégé * | 1,2,6,7 | |
| X | WPIL, FILE SUPPLIER, access. no. 89-201449 (28), Derwent Publications Ltd., Londres, GB;<br>& JP-A-1 138 300 (ASAHI GLASS CO.) 31 Mai 1989<br>* abrégé * | 1,2,6,7 | |
| Y | IDEM | 1-7 | |
| X | WPIL, FILE SUPPLIER, access. no. 89-197795 (27), Derwent Publications Ltd., Londres, GB;<br>& JP-A-1 137 259 (ASAHI GLASS CO.) 30 Mai 1989<br>* abrégé * | 1,2,6,7 | **DOMAINES TECHNIQUES RECHERCHES (Int. Cl.5 )**<br><br>C11D<br>C23G |
| Y | IDEM | 1-7 | |
| Y | WO-A-8 910 984 (ALLIED-SIGNAL)<br>* revendications * | 1-7 | |
| Y | EP-A-0 378 140 (KALI-CHEMIE)<br>* page 3, lignes 30-36; page 5, composition 3; revendications * | 1-7 | |

Le présent rapport a été établi pour toutes les revendications

| Lieu de la recherche | Date d'achèvement de la recherche | Examinateur |
|---|---|---|
| LA HAYE | 21 NOVEMBRE 1991 | GRITTERN A.G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)